# EUROPÄISCHE PATENTSCHRIFT

(11) **EP 2 953 436 B1**
(45) Veröffentlichungstag und Bekanntmachung des Hinweises auf die Patenterteilung: **22.07.2020**
(21) Anmeldenummer: 15169478.3
(22) Anmeldetag: 27.05.2015
(51) Int. Cl.: H05K 5/02, H05K 3/34

(54) **VERFAHREN ZUM HERSTELLEN EINES ELEKTRONISCHEN VERBINDUNGSELEMENTS**
METHOD FOR MANUFACTURING AN ELECTRONIC CONNECTING ELEMENT
PROCÉDÉ DE FABRICATION D'UN ÉLÉMENT DE CONNEXION ÉLECTRONIQUE

(30) Priorität: 06.06.2014 DE 102014107997
(43) Veröffentlichungstag der Anmeldung: 09.12.2015
(73) Patentinhaber: Neuschäfer Elektronik GmbH, 35066 Frankenberg (DE)
(72) Erfinder: Neuschäfer, Wilfried, 35066 Frankenberg (DE)
(74) Vertreter: Patentanwälte Olbricht Buchhold Keulertz

(56) Entgegenhaltungen:
- DE-A1- 19 735 904
- JP-A- H09 106 860
- US-A- 3 889 365
- US-A1- 2009 004 888
- US-B1- 6 369 345

## Beschreibung

Die Erfindung betrifft ein Verfahren zum Herstellen eines elektronischen Verbindungselements gemäß dem Oberbegriff von Anspruch 1.

Üblicherweise werden in der Elektronik elektrische Bauelemente auf Leiterplatten angeordnet, die elektrisch leitende, fest haftende Verbindungen als Leiter aufweisen. Dabei dienen die Leiterplatten nicht nur zur elektrischen Kontaktierung, sondern auch als Träger für elektronische Bauelemente, wie Anzeigen, Bedien- oder Stellglieder einer elektronischen Schaltung, die für einen Benutzer zugänglich angeordnet sein müssen.

Die Leiterplatten werden dabei bekanntermaßen in Bestückungsautomaten in Oberflächenmontagetechnik (SMT) bestückt, wobei die elektronischen Bauelemente als oberflächenmontierbare Bauelemente (SMD) ausgebildet sind. Derartige Bauelemente besitzen üblicherweise keine Drahtanschlüsse, sondern sind mit Lötflächen versehen, mit denen sie auf entsprechende Anschlussflächen der Leiterplatten verlötet werden. Die Anschlussflächen der Leiterplatten sind dafür mit Lötpaste versehen, die aufgeschmolzen werden, und so die Bauelemente und die Leiter miteinander verbinden.

Die elektronischen Bauteile werden häufig in räumlich beengten Gehäusen untergebracht. Dabei wird regelmäßig gefordert, die elektronischen Bauteile oberflächennah zu platzieren, beispielsweise dann, wenn diese als LED oder als Bedienelement ausgebildet sind.

Dafür ist es prinzipiell bekannt, die elektronischen Bauelemente mittels flexibler Drahtverbindungen mit entsprechenden Anschlussflächen der Leiterplatten zu verlöten. Diese Art der Verbindung ist aber nicht mit der üblichen Oberflächenmontagetechnik kompatibel, sondern erfordert nachträgliche Arbeitsschritte.

DE 197 35 904 A1 offenbart ein Verfahren zum Bestücken eines Leiterrahmens. Das Gehäuse mit Leiterrahmen, Schaltkreisen und ggf. weiteren Bauelementen bildet einen "Chip". Zweck solcher Leiterrahmen ist die Überbrückung eines Dimensionssprungs. Nach der Lehre der DE 197 35 904 A1 werden Anschlussenden des Leiterrahmens zum Anschluss des Chips beispielsweise an eine Leiterplatte nach definierten Vorgaben mit entsprechenden Kontakten eines ICs (integrierte Schaltkreises) oder anderen kleinskaligen Bauteilen verbunden.

Die von der DE 197 35 904 A1 offenbarten Verfahrensschritte umfassen das Beschichten eines Leiterrahmens mittels unbenetzbaren und gleichfalls benetzbaren Beschichtungen. An Flächen, an denen benetzbare Beschichtungen angebracht sind (Bondinseln), werden Bauteile befestigt. Hierbei können Bauteile verschiedene Segmente des Leiterrahmens miteinander verbinden. Die Befestigung der Bauteile erfolgt mittels Verlötung einer Lötpaste, die mittels eines Siebdruckverfahrens aufgebracht wird. Auf der mittels Siebdruckverfahren aufgebrachten Lötpaste werden in einem weiteren Verfahrensschritt Bauteile verlötet. Der Leiterrahmen weist Verankerungslöcher auf, die in einem weiteren Verfahrensschritt eine stoffschlüssige Verbindung des Leiterrahmens mit einer Verkapselung ermöglichen. Nachdem die Bauteile auf den Leiterrahmen gelötet sind, wird der Raum einer Verkapselung, die sich um den Leiterrahmen (bis auf die Anschlussenden) erstreckt, nämlich mittels eines Kapselungsmittels verfüllt, wobei das Verkapselungsmittel die Verankerungslöcher vollständig durchdringt. Der Leiterrahmen weist weiterhin Verbindungsstücke zwischen den Anschlussenden auf, die während des Verfahrens die Stabilität des Leiterrahmens gewährleisten sollen. Die Verbindungsstücke werden nach der Verkapselung der Bauteile und des Leiterrahmens zwischen den Anschlussenden herausgetrennt, da die Verkapselung eine hinreichende mechanische Stabilität gewährleistet.

US 6 369 345 B1 offenbart ein Verfahren und eine Vorrichtung zum Wiederaufschmelzlöten (Reflow-Löten) mittels Lötpaste und einer Lichtquelle.

JP H09 106860 A offenbart ein Verfahren zum Verbinden von Anschlussstücken an eine Diode, ohne dass ein Lötmittelüberfluss eintritt. Hierbei weisen Anschlusstücke entsprechende Ausnehmungen auf, die dieses verhindern sollen.

Aus US 3 889 365 A ist ein Verfahren zum Herstellen eines elektronischen Verbindungselements bekannt, das ein elektrisch leitfähiges Kontaktteil und ein elektronisches Bauelement und ein weiteres elektrisch leitfähiges Kontaktteil aufweist. Verfahrensgemäß wird auf einem Trägersubstrat an Verbindungsstellen des Verbindungselements ein Lot aufgebracht, wobei das Kontaktteil und das Bauelement gleichzeitig derart auf dem Trägersubstrat platziert sind, dass sie an den Verbindungsstellen überlappen und miteinander verlötet werden. Das Lot wird insbesondere aufgeschmolzen, wobei das Kontaktteil mit dem Bauelement verlötet wird. Anschließend wird das Trägersubstrat entfernt.

Der Erfindung liegt nun die Aufgabe zugrunde, die Nachteile des Stands der Technik zu beseitigen und ein Verfahren zum Herstellen eines Verbindungselementes anzugeben, das mittels Oberflächenmontagetechnik montierbar ist und räumlich verformt werden kann. Dabei soll die Lösung möglichst einfach automatisierbar und reproduzierbar sein sowie kostengünstig umgesetzt werden können. Insbesondere soll eine Herstellung des Verbindungselementes mittels einen zur Oberflächenmontage geeigneten Bestückungsautomaten möglich sein.

Erfindungsgemäß wird diese Aufgabe durch ein Verfahren mit den Merkmalen des Anspruchs 1 gelöst. Ausgestaltungen sind Gegenstand der Ansprüche 2 bis 8.

Bei einem Verfahren zum Herstellen eines elektronischen Verbindungselementes, das mindestens ein elektrisch leitfähiges Kontaktteil und mindestens ein weiteres elektrisch leitfähiges Kontaktteil und/oder ein elektronisches Bauelement aufweist, ist erfindungsgemäß vorgesehen, dass auf einem Trägersubstrat an Verbindungsstellen des Verbindungselementes Lötpaste aufgebracht wird, wobei das Kontaktteil, das weitere Kontaktteil und/oder das Bauelement auf dem Trägersubstrat derart platziert werden, dass sie an den Verbindungstellen überlappen und miteinander verlötbar sind, wobei sie auf der Lötpaste zu liegen kommen, wobei die Lötpaste aufgeschmolzen wird und das Kontaktteil mit dem Bauelement verlötet wird und anschließend das Trägersubstrat wieder entfernt wird.

Die Lötpaste geht also keine dauerhafte Verbindung mit dem Trägersubstrat ein, sondern kann nach dem Lötvorgang genauso wie das oder die elektrisch leitfähigen Kontaktteile sowie das gegebenenfalls elektronische Bauelement wieder von der Leiterplatte entfernt werden. Damit ist es möglich, das gesamte elektronische Verbindungselement, das ein oder mehrere elektrisch leitfähige Kontaktteile und/oder ein oder mehrere elektronische Bauelemente umfasst, mittels üblicher Oberflächenmontagetechniken herzustellen. Die elektrisch leitfähigen Kontaktteile ermöglichen dann nach Entfernen des Trägersubstrats eine relativ freie räumliche Verformung des Verbindungselementes, wobei durch das Vorsehen entsprechender Verbindungsstellen bei mehreren elektrischen Kontaktteilen gezielt versteifte Bereiche ausgebildet werden können, die eine gewünschte Verformung zum einen vereinfachen und zum anderen reproduzierbar machen.

Vorzugsweise wird dabei das elektronische Bauelement beidseitig mit Kontaktteilen verbunden. Das elektronische Bauelement ist also sozusagen in einen Leiter eingebunden, der durch die elektrisch leitfähigen Kontaktteile gebildet wird. Die Enden des Verbindungselementes, die jeweils ein Kontaktteil aufweisen, können dann mit der Herstellung des elektronischen Verbindungselementes mit einer Leiterplatte verlötet werden. In einem einzigen Bestückungsvorgang kann so nicht nur eine komplette Leiterplatte bestückt und verlötet werden, sondern auch das elektronische Verbindungselement mit dem elektronischen Bauelement in räumlich verformbarer Weise an der Leiterplatte in signalübertragender Weise angeschlossen werden.

Bevorzugterweise wird die Lötpaste mittels Schablonendruck aufgebracht. Damit ist ein sehr präzises Aufbringen der Lötpaste möglich, sodass auch das gesamte elektronische Verbindungselement entsprechend genau gefertigt werden kann.

In einer bevorzugten Weiterbildung sind auf dem Trägersubstrat Umrandungen ausgebildet, in die die Lötpaste eingebracht wird. Da die Lötpaste keine feste Verbindung mit dem Trägersubstrat eingehen soll, ist es wünschenswert, dass eine Haftung zwischen der Lötpaste und dem Trägersubstrat nicht allzu hoch ist. Um dennoch eine definierte Lage der Lötpaste auf dem Trägersubstrat zu erhalten, können hier Umrandungen vorgesehen sein. Dabei sind die Umrandungen beispielsweise als Erhebungen aufgebracht oder umranden eine in das Trägersubstrat eingebrachte Vertiefung.

Bevorzugterweise wird das Trägersubstrat mit dem elektronischen Bauelement und dem mindestens einen Kontaktteil mit einem Bestückungsautomaten bestückt, wobei im Bestückungsautomaten das Bauelement und das Kontaktteil verlötet werden. Eine vollautomatisierte Fertigung des elektronischen Verbindungselementes ist damit möglich, wobei dies gleichzeitig an eine Leiterplatte angeschlossen werden kann. Dabei kann anschließend beispielsweise manuell eine gewünschte räumliche Verformung des Verbindungselementes erfolgen, um dieses entsprechend in einem Gehäuse oder ähnlichem zu platzieren.

Bevorzugterweise werden Kontaktteile aus einem Kupfermaterial verwendet. Damit sind diese ausreichend leitfähig und elastisch verformbar. Darüber hinaus ist Kupfer einfach verarbeitbar und insbesondere gut lötbar.

Vorzugsweise weisen die Kontaktteile an ihren Enden eine Aussparung auf und werden derart überlappend auf der Lötpaste angeordnet, dass die Aussparungen der miteinander zu verbindenden Kontaktteile zumindest teilweise miteinander fluchten. Damit ist eine ausreichende Benetzung der Kontaktteile in den Verbindungsstellen gewährleistet, sodass mittels Lötens ein sicherer elektrischer Kontakt hergestellt werden kann.

In einer bevorzugten Weiterbildung werden mehrere Kontaktteile netzförmig miteinander verbunden. Durch eine entsprechende Form dieses Netzes wird eine mögliche räumliche Verformung beeinflusst beziehungsweise vorgegeben. Dabei können beispielsweise durch eine Parallelverlegung mehrerer Kontaktteile eine höhere Strombelastbarkeit und/oder eine höhere Sicherheit erreicht werden.

Bei einem elektronischen Verbindungselement, das nach dem erfindungsgemäßen Verfahren hergestellt wird, ist vorgesehen, dass zumindest das Kontaktteil, das mit dem Bauelement verlötet ist, räumlich verformbar ist. Damit ist es möglich, das Bauelement an einer gewünschten Stelle im Raum zu positionieren.

Die Länge und die Anzahl der Kontaktteile sind dabei von der gewünschten Verformung abhängig, also davon, wo das Bauelement im Verhältnis beispielsweise zu einer Leiterplatte positioniert werden soll. Dabei hat es sich herausgestellt, dass es günstig ist, wenn die Kontaktteile einen rechteckigen Querschnitt aufweisen, wobei insbesondere eine Breite zwischen 0,5 mm und 1,5 mm sowie eine Dicke zwischen 100 µm und 300 µm liegt, während eine Länge der Kontaktteile insbesondere zwischen 1 mm und 20 mm beträgt. Abweichende Maße der Kontaktteile sind ebenfalls möglich. Insbesondere durch die Aneinanderreihung mehrerer Kontaktteile kann dabei auch ein relativ langes elektronisches Verbindungselement hergestellt werden.

Die Erfindung wird im Folgenden anhand bevorzugter Ausführungsbeispiele in Verbindung mit den Zeichnungen näher beschrieben. Hierin zeigen:
- Fig. 1: ein Trägersubstrat mit bereits aufgebrachter Lötpaste,
- Fig. 2: das mit Kontaktteilen bestückte Trägersubstrat nach Figur 1,
- Fig. 3: ein fertiggestelltes elektronisches Verbindungselement,
- Fig. 4: ein an eine Leiterplatte angeschlossenes Verbindungselement und
- Fig. 5: zwei miteinander verbundene Kontaktteile eines Verbindungselementes.

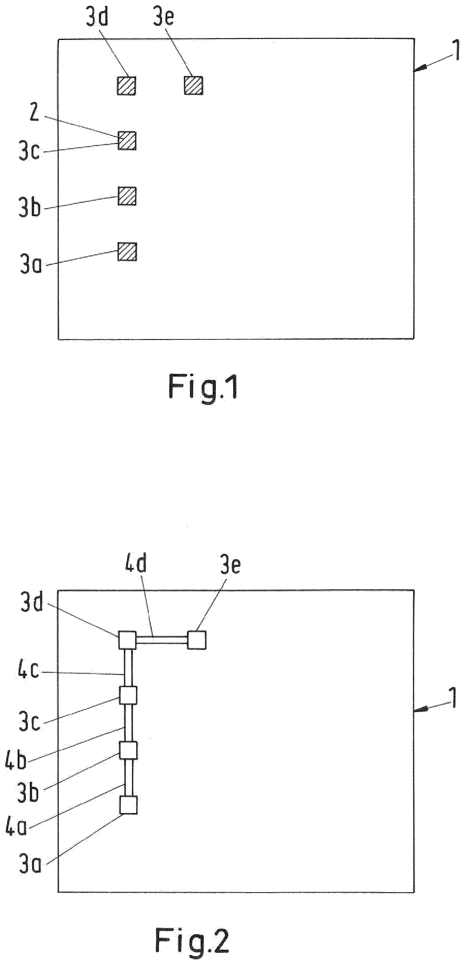

In Figur 1 ist ein Trägersubstrat 1 gezeigt, auf das Lötpaste 2 im Bereich gewünschter Verbindungsstellen 3a bis 3e beispielsweise mittels Schablonendruck aufgetragen worden ist. Dabei sind die Verbindungsstellen 3a bis 3e durch entsprechende Umrandungen definiert.

In Figur 2 sind nun bereits Kontaktteile 4a bis 4d auf dem Trägersubstrat derart platziert, dass sie sich mit ihren Enden im Bereich der Verbindungsstellen 3a bis 3e überlappen, wobei sie jeweils auf Lötpaste 2 zu liegen kommen. Die Kontaktteile sind dabei beispielsweise aus Kupfer mit einer Dicke von 200 µm hergestellt, wobei eine Breite beispielsweise 1 mm beträgt. Das so mit den Kontaktteilen 4a bis 4d und der Lötpaste 2 bestückte Trägersubstrat kann nun erwärmt werden, so dass die Kontaktteile 4a bis 4d mittels Schmelzlötens miteinander verbunden werden. Anschließend werden die Kontaktteile 4a bis 4d einschließlich der Lötpaste vom Trägersubstrat gelöst und bilden ein elektronisches Verbindungselement.

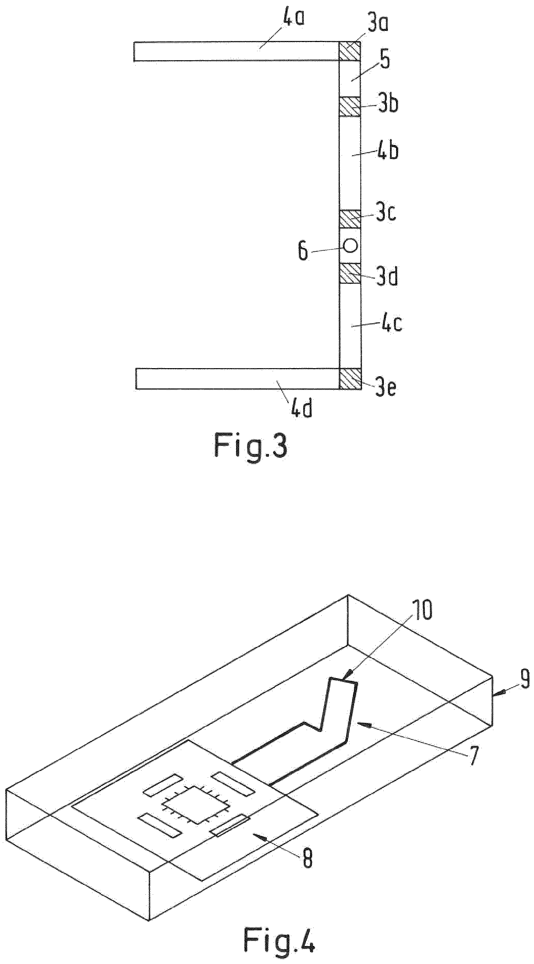

Ein fertiggestelltes elektronisches Verbindungselement ist beispielhaft in Figur 3 dargestellt. Dabei sind als elektronische Bauelemente ein elektrischer Widerstand 5 und eine lichtemittierende Diode (LED) 6 in das elektronische Verbindungselement eingebunden. Aber auch andere elektronische Bauelemente, wie beispielsweise Spulen, Kondensatoren, Schalter und Ähnliches können in das Verbindungselement integriert werden.

Figur 4 zeigt nun ein elektronisches Verbindungselement 7, das an einer Leiterplatte 8 angeschlossen ist, die mit einer elektronischen Schaltung versehen ist. Dabei ist die Leiterplatte 8 mit dem Verbindungselement 7 in einem Gehäuse 9 angeordnet. Das Verbindungselement 7 ist räumlich verformt, um ein elektronisches Bauelement 10 des Verbindungselementes 7 versetzt gegenüber der Leiterplatte 8 anzuordnen. Das elektronische Bauelement 10 kann so an einer Oberfläche des Gehäuses 9 platziert werden, um einfach zugänglich zu sein.

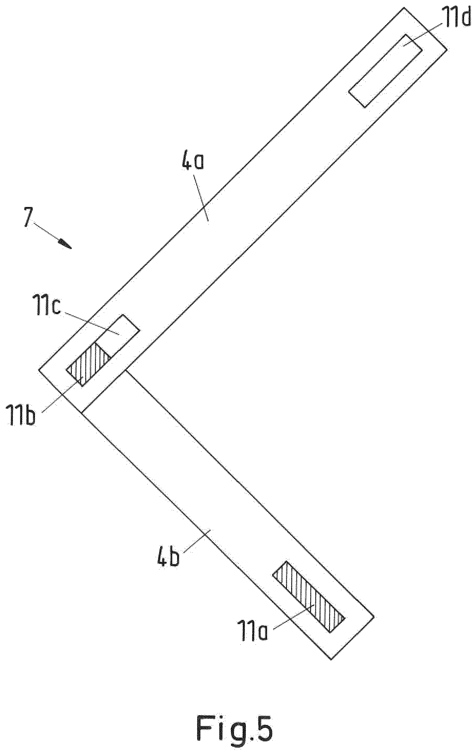

In Figur 5 ist nun ein zwei Kontaktteile 4a, 4b aufweisendes elektronisches Verbindungselement 7 dargestellt. Die Kontaktteile 4a, 4b weisen dabei an ihren Enden jeweils durchgehende Aussparungen 11a, 11b, 11c, 11d auf. Dabei sind die Kontaktteile 4a, 4b an der Verbindungsstelle derart überlappend miteinander angeordnet, dass die Aussparungen 11b und 11c teilweise miteinander fluchten. Lötpaste kann so beim Verlöten durch die Aussparungen hindurchtreten und die Enden beider Kontaktteile 4a, 4b ausreichend benetzen, sodass eine sichere Verbindung erhalten wird.

Das erfindungsgemäße Verfahren mit dem elektronischen Verbindungselement ermöglicht eine einfache Anpassung elektronischer Baugruppen an unterschiedlichste Gehäuseformen. Dabei werden die einzelnen Elemente des Verbindungselementes, also insbesondere die Kontaktteile und elektronischen Bauelemente, auf einem Trägersubstrat angeordnet und dort verlötet, wobei das Trägersubstrat aber nur für eine ausreichende mechanische Stabilität während des Positionierens und des Lötvorgangs genutzt wird und anschließend wieder entfernt wird. Somit kann das hergestellte Verbindungselement anschließend frei räumlich verformt werden, wobei dennoch eine Herstellung mittels bekannter Oberflächenmontagetechniken möglich ist. Insbesondere kann die Herstellung des Verbindungselementes gleichzeitig mit der Bestückung und Montage einer Leiterplatte erfolgen, das Verbindungselement also in einem Arbeitsgang auch an die Leiterplatte angeschlossen werden.

Die Kontaktteile bestehen dabei vorzugsweise aus Kupfer in Verbindung mit anderen, lötbaren Metallteilen und können in unterschiedlichen Längen und Formen eingesetzt werden. Für die spätere räumliche Verformung des Verbindungselementes können dabei entsprechende Vorrichtungen vorgesehen werden, die beispielsweise eine automatische Verformung ermöglichen. Es ist aber auch denkbar, dass die Verformung manuell vorgenommen wird.

## Patentansprüche

1. Verfahren zum Herstellen eines elektronischen Verbindungselements (7), das mindestens ein elektrisch leitfähiges Kontaktteil (4a-4d) und mindestens ein elektronisches Bauelement (5, 6, 10) und/oder ein weiteres elektrisch leitfähiges Kontaktteil (4a-4d) aufweist, wobei
- auf einem Trägersubstrat (1) an Verbindungsstellen (3a-3e) des Verbindungselements (7) Lötpaste (2) aufgebracht wird,
- das Kontaktteil (4a-4e) und das Bauelement (5, 6, 10) auf dem Trägersubstrat (1) derart platziert werden, dass sie an den Verbindungsstellen (3a-3e) überlappen und miteinander verlötbar sind, wobei sie auf der Lötpaste (2) zu liegen kommen,
- die Lötpaste (2) aufgeschmolzen wird, wobei das Kontaktteil (4a-4d) mit dem Bauelement (5, 6, 10) verlötet wird,
- das Trägersubstrat (1) entfernt wird.

2. Verfahren nach Anspruch 1, **dadurch gekennzeichnet, dass** das elektronische Bauelement (5, 6, 10) beidseitig mit Kontaktteilen (4a-4d) verbunden wird.

3. Verfahren nach Anspruch 1 oder 2, **dadurch gekennzeichnet, dass** die Lötpaste (2) mittels Schablonendruck aufgebracht wird.

4. Verfahren nach einem der vorhergehenden Ansprüche, **dadurch gekennzeichnet, dass** auf dem Trägersubstrat (1) Umrandungen ausgebildet sind, in die die Lötpaste (2) eingebracht wird.

5. Verfahren nach einem der vorhergehenden Ansprüche, **dadurch gekennzeichnet, dass** das Trägersubstrat (2) mit dem elektronischen Bauelement (5, 6, 10) und dem mindestens einem Kontaktteil (4a-4e) mit einem Bestückungsautomaten bestückt wird, wobei im Bestückungsautomaten das Bauelement (5, 6, 10) und das Kontaktteil (4a-4e) verlötet werden.

6. Verfahren nach einem der vorhergehenden Ansprüche, **dadurch gekennzeichnet, dass** für die Kontaktteile (4a-4e) ein Kupfermaterial verwendet wird.

7. Verfahren nach einem der vorhergehenden Ansprüche, **dadurch gekennzeichnet, dass** die Kontaktteile (4a-4e) an ihren Enden eine Aussparung (11a-11d) aufweisen und derart überlappend auf der Lötpaste (2) angeordnet werden, dass Aussparungen (11a-11d) der miteinander zu verbindenden Kontaktteile (4a-4e) zumindest teilweise miteinander fluchten.

8. Verfahren nach einem der vorhergehenden Ansprüche, **dadurch gekennzeichnet, dass** mehrere Kontaktteile (4a-4e) netzförmig miteinander verbunden werden.

## Claims

1. Method for manufacturing an electronic connecting element (7), which has at least one electroconductive contact part (4a-4d) and at least one electronic component (5, 6, 10) and/or an additional electroconductive contact part (4a-4d), wherein
- soldering paste (2) is applied to a carrier substrate (1) on connecting points (3a-3e) of the connecting element (7),
- the contact part (4a-4e) and the component (5, 6, 10) are placed on the carrier substrate (1) such that they overlap on the connecting points (3a-3e) and can be soldered to one another, wherein they come to lie on the soldering paste (2),
- the soldering paste (2) is melted, wherein the contact part (4a-4d) is soldered to the component (5, 6, 10),
- the carrier substrate (1) is removed.

2. Method according to claim 1, **characterised in that** the electronic component (5, 6, 10) is connected on both sides to contact parts (4a-4d).

3. Method according to claim 1 or 2, **characterised in that** the soldering paste (2) is applied by means of stencil printing.

4. Method according to any of the preceding claims, **characterised in that** on the carrier substrate (1) edges are formed into which the soldering paste (2) is inserted.

5. Method according to any of the preceding claims, **characterised in that** the carrier substrate (2) is fitted with the electronic component (5, 6, 10) and the at least one contact part (4a-4e) by means of an automatic placement machine, wherein in the automatic placement machine the component (5, 6, 10) and the contact part (4a-4e) are soldered.

6. Method according to any of the preceding claims, **characterised in that** a copper material is used for the contact parts (4a-4e).

7. Method according to any of the preceding claims, **characterised in that** the contact parts (4a-4e) have a recess (11a-11d) at their ends and are arranged in an overlapping manner on the soldering paste (2), **in that** recesses (11a-11d) of the contact parts (4a-4e) to be connected to one another are at least partly in alignment with one another.

8. Method according to any of the preceding claims, **characterised in that** a plurality of contact parts (4a-4e) are connected to one another in the form of a net.

## Revendications

1. Procédé de fabrication d'un élément de connexion électronique (7) qui présente au moins une partie de contact conductrice de l'électricité (4a-4d) et au moins un composant électronique (5, 6, 10) et/ou une autre partie de contact conductrice de l'électricité (4a-4d), selon lequel
- sur un substrat de support (1), une pâte à souder (2) est appliquée à des jonctions (3a-3e) de l'élément de connexion (7),
- la partie de contact (4a-4e) et le composant (5, 6, 10) sont placés sur le substrat de support (1) de façon qu'ils chevauchent au niveau des jonctions (3a-3e) et qu'ils soient soudables l'un à l'autre, selon lequel ils reposent sur la pâte à souder (2),
- la pâte à souder (2) est fondue, selon lequel la partie de contact (4a-4d) est soudée au composant (5, 6, 10),
- le substrat de support (1) est enlevé.

2. Procédé selon la revendication 1, **caractérisé en ce que** le composant électronique (5, 6, 10) est connecté des deux côtés à des parties de contact (4a-4d).

3. Procédé selon la revendication 1 ou 2, **caractérisé en ce que** la pâte à souder (2) est appliquée par impression au pochoir.

4. Procédé selon l'une des revendications précédentes, **caractérisé en ce que** des bords sont formés sur le substrat de support (1), dans lesquels la pâte à souder (2) est introduite.

5. Procédé selon l'une des revendications précédentes, **caractérisé en ce que** le substrat de support (2) est équipé du composant électronique (5, 6, 10) et de la au moins une partie de contact (4a-4e) à l'aide d'un automate d'équipement, selon lequel le composant (5, 6, 10) et la partie de contact (4a-4e) sont soudés dans l'automate d'équipement.

6. Procédé selon l'une des revendications précédentes, **caractérisé en ce qu'**un matériau en cuivre est utilisé pour les parties de contact (4a-4e).

7. Procédé selon l'une des revendications précédentes, **caractérisé en ce que** les parties de contact (4a-4e) présentent un évidement (11a-11d) à leurs extrémités et sont disposées en recouvrant la pâte à souder (2) de façon que des évidements (11a-11d) des parties de contact (4a-4e) à connecter l'une à l'autre soient au moins partiellement alignés l'un avec l'autre.

8. Procédé selon l'une des revendications précédentes, **caractérisé en ce que** plusieurs parties de contact (4a-4e) sont connectées l'une à l'autre de façon réticulaire.
